(19) **Europäisches Patentamt**

**European Patent Office**

**Office européen des brevets**

(11) **EP 1 216 502 B1**

(12) **EUROPÄISCHE PATENTSCHRIFT**

(45) Veröffentlichungstag und Bekanntmachung des Hinweises auf die Patenterteilung:
**02.05.2003 Patentblatt 2003/18**

(21) Anmeldenummer: **00971289.4**

(22) Anmeldetag: **27.09.2000**

(51) Int Cl.7: **H03G 3/00**

(86) Internationale Anmeldenummer:
**PCT/EP00/09454**

(87) Internationale Veröffentlichungsnummer:
**WO 01/024360 (05.04.2001 Gazette 2001/14)**

(54) **REGELKREIS FÜR DIGITALE SIGNALE**

CONTROL LOOP FOR DIGITAL SIGNALS

CIRCUIT DE REGLAGE DESTINE A DES SIGNAUX NUMERIQUES

(84) Benannte Vertragsstaaten:
**DE FR GB IT NL**

(30) Priorität: **30.09.1999 DE 19947048**

(43) Veröffentlichungstag der Anmeldung:
**26.06.2002 Patentblatt 2002/26**

(73) Patentinhaber: **Micronas Munich GmbH**
**81541 München (DE)**

(72) Erfinder: **MENKHOFF, Andreas**
**81927 München (DE)**

(74) Vertreter: **Bickel, Michael**
**Westphal & Partner**
**Mozartstrasse 8**
**80336 München (DE)**

(56) Entgegenhaltungen:
**US-A- 4 764 967**

- **TAVARES G ET AL: "HIGH PERFORMANCE ALGORITHMS FOR DIGITAL SIGNAL PROCESSING AGC" PROCEEDINGS OF THE INTERNATIONAL SYMPOSIUM ON CIRCUITS AND SYSTEMS,US,NEW YORK, IEEE, Bd. CONF. 23, 1. Mai 1990 (1990-05-01), Seiten 1529-1532, XP000167084**
- **PATENT ABSTRACTS OF JAPAN vol. 015, no. 058 (E-1032), 12. Februar 1991 (1991-02-12) & JP 02 285804 A (MATSUSHITA ELECTRIC IND CO LTD), 26. November 1990 (1990-11-26)**
- **ANONYMOUS: "Adaptive Digital Automatic Gain Control" IBM TECHNICAL DISCLOSURE BULLETIN, Bd. 27, Nr. 10B, 1. März 1985 (1985-03-01), Seiten 6334-6335, XP002155922 New York, US**

## Beschreibung

Die Erfindung bezieht sich auf einen Regelkreis, bei dem ein Eingangssignal durch Multiplikation mit einem Integratorwert in ein Ausgangssignal, das im Mittel einen konstanten Referenzwert aufweist, umgewandelt wird.

Solche Regelkreise werden beispielsweise als Schaltungen zur automatischen Verstärkungsanpassung, sogenannten AGCs (automatic gain control), von digitalen Signalen benutzt. Bei einer automatischen Verstärkungsanpassung wird aus einem Eingangssignal ein im zeitlichen Mittel konstantes Ausgangssignal erzeugt, dessen Pegel in der Regel einstellbar und unabhängig vom Pegel des Eingangssignals ist.

In Empfangsschaltungen für Hochfrequenzsignale wird die AGC eingesetzt, um unabhängig von der Feldstärke des empfangenen Signals der Eingangsstufe ein Zwischensignal für die weitere Signalverarbeitung bereitzustellen, dessen Pegel im zeitlichen Mittel konstant ist. Bei der Dimensionierung der Signalverarbeitungseinheiten kann dann dieser Pegel zugrundegelegt werden.

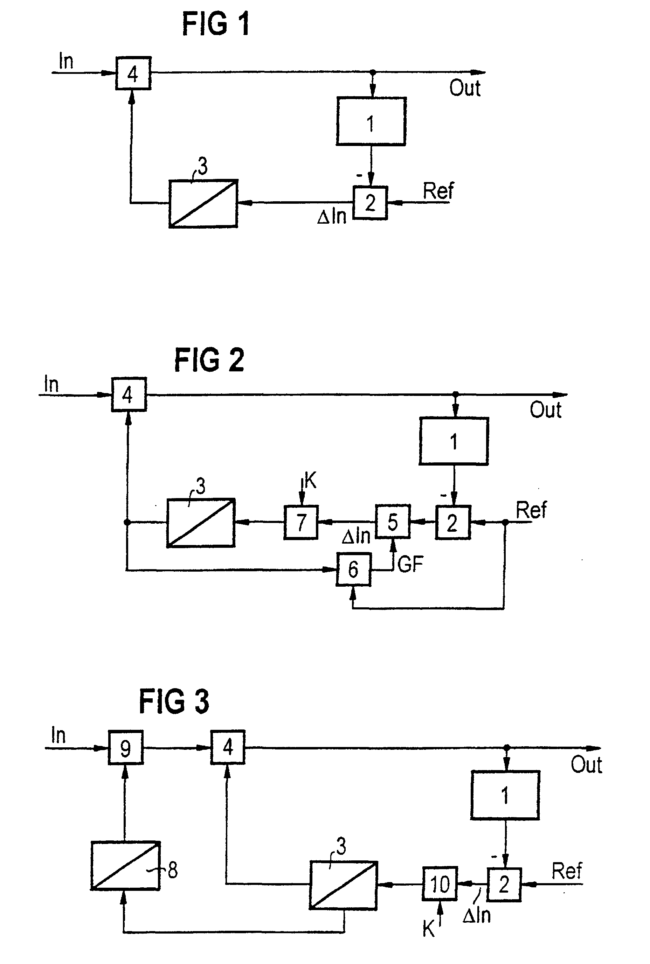

In Figur 1 ist ein bekannter Regelkreis für digitale Signale dargestellt. Die Energie eines Ausgangssignals OUT soll im Mittel einen konstanten Wert aufweisen, welcher über einen Referenzwert REF eingestellt werden kann. Energiereiche Eingangssignale müssen somit in der Amplitude abgesenkt, energiearme Eingangssignale in der Amplitude angehoben werden.

Das Ausgangssignal OUT wird zunächst in einem Signalwandler 1 so angepaßt, daß es mit dem Referenzwert REF verglichen werden kann. Ist Das Ausgangssignal OUT beispielsweise ein elektrischer Strom, so wird dem Signalwandler eine zu dem Strom proportionale Spannung abgeleitet, die dann mit einer Referenzspannung verglichen wird. Der Signalwandler 1 kann das Ausgangssignal OUT auch so anpassen, daß das Regelverhalten des Regelkreises möglichst günstig ist. Dazu eignen sich Signalverarbeitungsfunktionen wie beispielsweise Betragsbildung, die Quadrierung oder die Berechnung des Klirrfaktors. Bei Wahl einer der aufgeführten Signalverarbeitungsfunktionen ist sichergestellt, daß auch bei negativem Ausgangssignal OUT nur positive Werte für den Vergleich herangezogen werden.

Der Vergleich selbst besteht aus einer Differenzbildung mit einem Differenzglied 2, bei dem das angepaßte Ausgangssignal OUT vom Referenzwert REF subtrahiert wird. Das Differenzglied 2 liefert eine Differenz $\Delta$IN. Die Differenz $\Delta$IN wird einem Integriererglied 3 zugeführt, das aus ihr einen Integratorwert IW ermittelt. Das Integriererglied 3 addiert die Differenz $\Delta$IN auf. Bei positiver Differenz $\Delta$IN wird der Integratorwert IW erhöht, bei negativer Differenz $\Delta$IN erniedrigt. In einem Multiplikationsglied 4 wird das Eingangssignal IN mit dem Integratorwert IW multipliziert. Das Ergebnis dieser Multiplikation ist das Ausgangssignal OUT.

Eine ähnliche Schaltungsstruktur ist z.B. aus IBM TDB Vol. 27, No. 10B, März 1985, Seiten 6334 und 6335 bekannt.

Die Schaltung nach Figur 1 kann mathematisch beschrieben werden mit

$$\Delta IN = REF - IN * IW.$$

Im eingeschwungenen Zustand, also wenn der Regelkreis in einen stationären Zusand eingeschwungen ist, ist $\Delta$IN = 0. Daraus ergibt sich

$$\Delta IN = REF - IN * IW = 0,$$

oder umgeformt

$$IW = REF/IN.$$

Daraus erhält man schließlich den gewünschten Ausgangswert OUT zu

$$OUT = IN * IW = IN * REF/IN = REF.$$

Nachteil dieser Schaltung ist die lange Einschwingzeit, die erforderlich ist, wenn die Energie des Eingangssignals IN stark von dem Referenzwert REF abweicht. Bei einer großen Abweichung werden mehrere Hundert Zyklen benötigt, um den Referenzwert REF genau einzustellen. Bei zeitkritischen Regelaufgaben ist diese lange Einschwingzeit nicht vertretbar.

Aufgabe der vorliegenden Erfindung ist es, einen Regelkreis zur Umwandlung eines Eingangssignals durch Multiplikation mit einem Integratorwert in ein Ausgangssignal, das im Mittel einen konstanten Referenzwert aufweist, anzugeben, der durch eine einfache Zusatzbeschaltung ein verbessertes Regelverhalten aufweist. Gelöst wird diese Aufgabe mit einem Regelkreis mit den Merkmalen des Patentanspruchs 1. Gelöst wird diese Aufgabe auch mit einem Regelkreis mit den Merkmalen des Patentanspruchs 4.

Die Erfindung hat den Vorteil, daß das Regelverhalten des bekannten Regelkreises mit einer nur geringen Zusatzbeschaltung erheblich verbessert werden kann. Die einzelnen Komponenten des bekannten Regelkreises können weiterhin verwendet werden.

Besonders vorteilhaft ist, daß die Multiplikationseinheiten und das Divisionsglied mit einfachen Schieberegistern (barrel shifter) realisiert werden können, wenn sich der konstante Faktor bzw. der Referenzwert als Potenz von 2 darstellen läßt.

Vorteilhafte Aus- und Weiterbildungen sind in Unteransprüchen gekennzeichnet.

Die Erfindung wird nachfolgend anhand von in den Figuren der Zeichnung dargestellten Ausführungsbeispielen näher erläutert. Entsprechende Elemente sind mit gleichen Bezugszeichen versehen. Es zeigen:

Figur 1 einen bekannten Regelkreis,
Figur 2 einen erfindungsgemäßen Regelkreis mit zusätzlicher Rückkopplung und
Figur 3 einen erfindungsgemäßen Regelkreis mit Zähler.

Gemäß einem ersten Ausführungsbeispiel nach Figur 2 ist ein Differenzglied 2 ausgangsseitig mit einem ersten Multiplikationsglied 5 verbunden. Das Differenzglied 2 weist Eingänge auf für einen Referenzwert REF und ein Ausgangssignal OUT. Das Ausgangssignal OUT kann, bevor es dem Differenzglied 2 zugeführt wird, durch einen Signalwandler 1 an den Referenzwert REF bezüglich der physikalischen Einheit angepaßt werden. Das Differenzglied 2 bildet aus dem Referenzsignal REF und dem Ausgangssignal OUT die Differenz und leitet diese an das erste Multiplikationsglied 5 weiter. Dieses multipliziert die Differenz $\Delta$IN mit einem Gewichtungsfaktor GF. Das Ergebnis wird an ein Integriererglied 3 weitergeleitet. Das Integriererglied 3 integriert die mit dem Gewichtungsfaktor GF gewichtete Differenz $\Delta$IN auf. Das Ergebnis dieser Integration gibt das Integriererglied 3 als Integratorwert IW an ein zweites Multiplikationsglied 4 weiter. Im zweiten Multiplikationsglied 4 wird ein Eingangssignal IN mit dem Integratorwert IW multipliziert. Das Ergebnis dieser Multiplikation des zweites Multiplikationsgliedes 4 stellt das Ausgangssignal OUT dar.

Der Gewichtungsfaktor GF wird aus dem Integratorwert IW abgeleitet und über das erste Multiplikationsglied 5 auf das Integriererglied 3 rückgekoppelt. Ein günstiges Regelverhalten ergibt sich, wenn als Gewichtungsfaktor GF nicht unmittelbar der Integratorwert IW herangezogen wird. Günstiger ist es, den Integratorwert IW durch den Referenzwert REF zu dividieren und damit die Differenz $\Delta$IN zu gewichten. Der Gewichtungsfaktor GF ist in diesem Fall der Quotient aus dem Integratorwert IW und dem Referenzwert REF. Zur Durchführung dieser Division IW/REF ist ein Divisionsglied 6 vorgesehen. Ein erster Eingang des Divisionsgliedes 6 ist mit einem Ausgang des Integrierergliedes 3 verbunden, um dem Divisionsglied 6 den Integratorwert IW zuzuführen. Ein zweiter Eingang des Divisionsgliedes 6 ist mit einem Eingang des Differenzgliedes 2 verbunden. Über den zweiten Eingang wird dem Divisionsglied 6 der Referenzwert REF zugeführt. Zusätzlich kann eine Multiplikationseinheit 7 zwischen dem ersten Multiplikationsglied 5 und dem Integriererglied 3 vorgesehen sein. Von dem Referenzwert REF wird das Ausgangssignal OUT subtrahiert und mit dem Gewichtungsfaktor GF, der sich aus IW/REF berechnet, gewichtet. Die gewichtete Differenz wird in der Multiplikationseinheit 7 mit einem konstanten Faktor K multipliziert. Durch geeignete Wahl des konstanten Faktors K kann das Regelverhalten weiter verbessert werden. Es ist dabei vorteilhaft, wenn der konstante Faktor K in der Einschwingphase des Regelkreises einen anderen Wert aufweist als im eingeschwungenen Zustand. Bei kleinem K (z. B. K = 0,1) braucht das Integriererglied 3 länger, bis die Differenz $\Delta$IN aufintegriert ist. Bei stark verrauschtem Eingangssignal IN ist eine längere Integrationszeit vorteilhaft. Im idealen Fall, bei dem das Eingangssignal kein Rauschen aufweist, kann K=1 gewählt werden, um eine schnelle Ausregelung zu erreichen.

Das Divisionsglied 6 und die Multiplikationseinheit 7 lassen sich besonders einfach mit Schieberegistern realisieren. Voraussetzung beim Divisionsglied dafür ist, daß sich der Referenzwert REF, bei der Multiplikationseinheit daß sich der konstante Faktor K als Potenz von 2 darstellen läßt. Die Multiplikation einer binären Zahl um 2 entspricht einer Verschiebung der binären Zahl um eine Stelle nach links. Analog dazu entspricht der Division einer binären Zahl durch 2 dem Verschieben der binären Zahl um eine Stelle nach rechts.

Gemäß einem zweiten Ausführungsbeispiel nach Figur 3 ist das Differenzglied 2 wiederum ausgangsseitig mit dem Integriererglied 3 verbunden. Das Differenzglied 2 subtrahiert von dem Referenzwert REF das eventuell in dem Signalwandler 1 angepaßte Ausgangssignal OUT und gibt die Differenz $\Delta$IN an das Integriererglied 3 weiter. Bei diesem Ausführungsbeispiel kann das Integriererglied 3 nur Werte zwischen einer unteren und einer oberen Schwelle annehmen. Liegt der Integratorwert bereits bei der oberen Schwelle, so erfolgt das weitere Aufintegrieren bei der unteren Schwelle. Liegt der Integratorwert IW bei der unteren Schwelle, so wird bei einer weiteren Unterschreitung bei der oberen Schwelle weiter zurückgezählt. Das Integriererglied 3 weist also einen Überlauf und einen Unterlauf auf. Es gibt neben dem Integratorwert IW an einem Übertragausgang UA ein Zählsignal aus, das jede Überschreitung einer der Schwellen an einen Zähler 8 weiterleitet. Dieser inkrementiert seinen Zählerstand im Falle des Überlaufs und dekrementiert den Zählerstand im Falle des Unterlaufs. Der Zähler 8 ist ausgangsseitig mit einem Eingangsmultiplikationsglied 9 verbunden. Das Eingangsmultiplikationsglied 9 multipliziert das Eingangssignal IN, mit dem Zählerstand der die Anzahl der Überschreitungen der unteren und oberen Schwelle darstellt. Das Ergebnis dieser Multiplikation wird dem zweiten Multiplikationsglied 4 zugeführt, das es mit dem Integratorwert IW multipliziert, um das Ausgangssignal OUT zu erhalten.

Mit dem Ausführungsbeispiel nach Figur 3 wird erreicht, daß das Eingangssignal IN mit einem Skalierungsfaktor skaliert wird. Der Skalierungsfaktor ist $2^n$, wobei n dem Zählerstand des Zählers 8 entspricht. Bei großen Abweichungen des Eingangssignals IN vom Referenzwert REF wird durch die Skalierung das Eingangssignal in die Größenordnung des Referenzwertes gebracht. Damit ist sichergestellt, daß das Verhältnis von Integratorwert zu Referenzwert nahe bei 1 liegt.

Eine weitere Verbesserung des Regelverhaltens wird erzielt, wenn zwischen dem Integriererglied 3 und dem Differenzglied 2 ein Zwischenmultiplikationsglied 10 vorgesehen wird. Durch dies wird die Differenz ΔIN mit dem Faktor K gewichtet.

## Patentansprüche

1. Regelkreis zur Umwandlung eines Eingangssignals (IN) durch Multiplikation mit einem Integratorwert (IW) in ein Ausgangssignal (OUT), das im Mittel einen konstanten Referenzwert (REF) aufweist, mit

   - einem ersten Multiplikationsglied (4) zur Multiplikation des Eingangssignals (IN) mit dem Integratorwert (IW),
   - einem Differenzglied (2) zur Bildung einer Differenz zwischen dem Ausgangssignal (OUT) und dem Referenzwert (REF) und
   - einem Integriererglied (3) zur Bildung des Integratorwertes (IW) aus einem Integratoreingangssignal,

   **dadurch gekennzeichnet,**
   **daß** ein zweites Multiplikationsglied (5) zwischen dem Differenzglied (2) und dem Integriererglied (3) vorgesehen ist zur Bildung des Integratorseingangssignals, aus der mit einem vom Integratorwert (IW) abgeleiteten Gewichtungsfaktor (GF) gewichteten Differenz.

2. Regelkreis nach Anspruch 1,
   **dadurch gekennzeichnet,**
   **daß** ein Divisionsglied (6) vorgesehen ist zur Berechnung des Gewichtungsfaktors (GF) durch Division des Integratorwertes (IW) durch den Referenzwert (REF).

3. Regelkreis nach Anspruch 1 oder 2,
   **dadurch gekennzeichnet,**
   **daß** zwischen das Integriererglied (3) und das zweite Multiplikationsglied (5) eine Multiplikationseinheit (7) zur Multiplikation des Integriererseingangssignals mit einem konstanten Faktor (K) geschaltet ist.

4. Regelkreis zur Umwandlung eines Eingangssignals (IN) durch Multiplikation mit einem Integratorwert (IW) in ein Ausgangssignal (OUT), das im Mittel einen konstanten Referenzwert (REF) aufweist, mit

   - einem ersten Multiplikationsglied (4) zur Multiplikation des Eingangssignals (IN) mit dem Integratorwert (IW),
   - einem Differenzglied (2) zur Bildung einer Differenz zwischen dem Ausgangssignal (OUT) und dem Referenzwert (REF) und
   - einem Integriererglied (3) zur Bildung des Integratorwertes (IW) aus einem Integratoreingangssignal,

   **dadurch gekennzeichnet,**
   **daß** vorgesehen ist eine Multiplikationseinheit (9) zur Skalierung des Eingangssignals (IN) mit einem von einem Zähler (8),der mit einem Ausgang (UA) des Integrierergliedes (3) verbunden ist und die Anzahl der Überschreitungen einer unteren und einer oberen Schwelle des Integratorwertes (IW) zählt, bestimmten Wert, wobei die Multiplikationseinheit und das Multiplikationsglied hintereinandergeschaltet sind.

5. Regelkreis nach Anspruch 4,
   **dadurch gekennzeichnet,**
   **daß** zwischen das Integriererglied (3) und das Differenzglied (2) eine weitere Multiplikationseinheit (10) zur Multiplikation des Integrierereingangssignals mit einem konstanten Faktor (K) geschaltet ist.

6. Regelkreis nach einem der Ansprüche 3 oder 5,
   **dadurch gekennzeichnet,**
   **daß** die Multiplikationseinheit (7; 10) als Schieberegister ausgeführt ist.

7. Regelkreis nach einem der Ansprüche 3 oder 5,
   **dadurch gekennzeichnet,**
   **daß** der konstante Faktor (K) in der Einschwingphase des Regelkreises einen anderen Wert aufweist als im eingeschwungenen Zustand.

## Claims

1. A control loop for converting an input signal (IN) by multiplication with an integrator value (IW) into an output signal (OUT), which on average comprises a constant reference value (REF), having

   - a first multiplication element (4) for the multiplication of the input signal (IN) with the integrator value (IW),
   - a differential element (2) for carrying out a subtraction between the output signal (OUT) and the reference value (REF) and
   - an integrating circuit (3) for forming the integrator value (IW) from an integrator input signal,

   **characterised in that** a second multiplication element (5) is provided between the differential element (2) and the integrating circuit (3) for forming the integrator input signal from the difference weighted with a weighting factor (GO) derived from the integrator value (IW).

2. A control loop according to Claim 1,

**characterised in that** a division element (6) is provided to calculate the weighting factor (GO) by dividing the integrator value (IW) by the reference value (REF).

3. A control loop according to Claim 1 or 2, **characterised in that** a multiplication unit (7) for multiplying the integrating input signal with a constant factor (K) is connected between the integrating circuit (3) and the second multiplication element (5).

4. A control loop for converting an input signal (IN) by multiplication with an integrator value (IW) into an output signal (OUT), which on average has a constant reference value (REF), having

   - a first multiplication element (4) for the multiplication of the input signal (IN) with the integrator value (IW),
   - a differential element (2) for carrying out a subtraction between the output signal (OUT) and the reference value (REF) and
   - an integrating circuit (3) for forming the integrator value (IW) from an integrator input signal,

   **characterised in that** a multiplication unit (9) is provided for scaling the input signal (IN) with a value determined by a counter (8), which is connected to an input (UA) of the integrating circuit (3) and counts the number of transgressions of a lower and an upper threshold of the integrator value (IW), where the multiplication unit and the multiplication element are connected one behind the outer.

5. A control loop according to Claim 4, **characterised in that** a further multiplication unit (10) for the multiplication of the integrating input signal with a constant factor (K) is connected between the integrating circuit (3) and the differential element (2).

6. A control loop according to one of Claims 3 or 5, **characterised in that** the multiplication unit (7; 10) is designed as a shift register.

7. A control loop according to one of Claims 3 or 5, **characterised in that** the constant factor (K) in the transient phase of the control loop has a different value than in the steady state.

**Revendications**

1. Circuit de réglage pour convertir un signal d'entrée (IN) par multiplication avec une valeur d'intégration (IW) en un signal de sortie (OUT) qui présente une valeur de référence (REF) constante en moyenne, avec

   - un premier élément de multiplication (4) pour multiplier le signal d'entrée (IN) avec la valeur d'intégration (IW),
   - un élément de différence (2) pour calculer une différence entre le signal de sortie (OUT) et la valeur de référence (REF) et
   - un élément d'intégration (3) pour calculer la valeur d'intégration (IW) à partir d'un signal d'entrée d'intégration,

   **caractérisé en ce qu'**
   un deuxième élément de multiplication (5) est prévu entre l'élément de différence (2) et l'élément d'intégration (3) afin de former le signal d'entrée d'intégration à partir de la différence pondérée avec un facteur de pondération (GF) dérivé de la valeur d'intégration (IW).

2. Circuit de réglage selon la revendication 1, **caractérisé en ce qu'**
   un élément de division (6) est prévu pour calculer le facteur de pondération (GF) en divisant la valeur d'intégration (IW) par la valeur de référence (REF).

3. Circuit de réglage selon la revendication 1 ou 2, **caractérisé en ce qu'**
   entre l'élément d'intégration (3) et le deuxième élément de multiplication (5) est branchée une unité de multiplication (7) pour multiplier le signal d'entrée d'intégration avec un facteur constant (K).

4. Circuit de réglage pour convertir un signal d'entrée (IN) par multiplication avec une valeur d'intégration (IW) en un signal de sortie (OUT) qui présente une valeur de référence (REF) constante en moyenne, avec

   - un premier élément de multiplication (4) pour multiplier le signal d'entrée (IN) avec la valeur d'intégration (IW),
   - un élément de différence (2) pour calculer une différence entre le signal de sortie (OUT) et la valeur de référence (REF) et
   - un élément d'intégration (3) pour calculer la valeur d'intégration (IW) à partir d'un signal d'entrée d'intégration,

   **caractérisé en ce qu'**
   on prévoit une unité de multiplication (9) pour cadrer le signal d'entrée (IN) avec une valeur déterminée par un compteur (8) qui est relié à une sortie (UA) de l'élément d'intégration (3) et qui compte le nombre des dépassements d'une limite inférieure et d'une limite supérieure de la valeur d'intégration (IW), l'unité de multiplication et l'élément de multiplication étant connectés l'un à la suite de l'autre.

**5.** Circuit de réglage selon la revendication 4, **caractérisé en ce qu'** entre l'élément d'intégration (3) et l'élément de différence (2) est connectée une autre unité de multiplication (10) pour multiplier le signal d'entrée d'intégration avec un facteur constant (K).

**6.** Circuit de réglage selon l'une des revendications 3 ou 5, **caractérisé en ce que** l'unité de multiplication (7, 10) est réalisée en tant que registre de décalage.

**7.** Circuit de réglage selon l'une des revendications 3 ou 5, **caractérisé en ce que** le facteur constant (K) présente dans la phase transitoire du circuit de réglage une autre valeur que dans le registre permanent.

# FIG 1

# FIG 2

# FIG 3